# FASCICULE DE BREVET EUROPEEN

(11) **EP 3 344 023 B1**
(45) Date de publication et mention de la délivrance du brevet: **21.07.2021**
(21) Numéro de dépôt: 17210518.1
(22) Date de dépôt: 22.12.2017
(51) Int. Cl.: H05K 7/14, H01L 25/07, H01L 27/02

(54) **ARCHITECTURE D'UN COMMUTATEUR TRIPHASÉ**
AUFBAU EINES DREHSTROM-UMSCHALTERS
ARCHITECTURE OF A THREE-PHASE SWITCH

(30) Priorité: 29.12.2016 FR 1663514
(43) Date de publication de la demande: 04.07.2018
(73) Titulaire: Commissariat à l'Energie Atomique et aux Energies Alternatives, 75015 Paris (FR)
(72) Inventeur: LEFEVRE, Guillaume, 73100 AIX LES BAINS (FR); ALVES RODRIGUES, Luis-Gabriel, 73000 CHAMBERY (FR); FERRIEUX, Jean-Paul, 38240 MEYLAN (FR)
(74) Mandataire: Cabinet Beaumont

(56) Documents cités:
- EP-A2- 2 367 281
- US-A1- 2013 336 033
- US-B1- 6 501 172

## Description

### Domaine

La présente description concerne de façon générale les systèmes électroniques de conversion d'énergie et plus particulièrement, la réalisation d'un onduleur de courant triphasé. La présente description concerne plus précisément l'architecture d'un convertisseur statique de puissance destiné à des applications de type onduleur de courant (courant continu CC - courant alternatif CA) .

### Exposé de l'art antérieur

Un convertisseur statique de puissance CC-CA triphasé est généralement basé sur deux ensembles de trois (ou trois ensembles de deux) interrupteurs électroniques, typiquement des transistors MOS de puissance (MOSFET) associés à des diodes.

On distingue les onduleurs de tension dans lesquels les transistors sont directement en série deux à deux et chaque transistor est équipé d'une diode en antiparallèle, et les onduleurs de courant dans lesquels chaque transistor est en série avec une diode pour constituer un interrupteur bidirectionnel en tension et unidirectionnel en courant. La présente description vise plus particulièrement les onduleurs de courant.

Dans des applications de puissance, les transistors et les diodes sont généralement réalisés individuellement sous la forme de composants discrets ou de puces nues. Chaque interrupteur à commutation commandée (transistor) ou à commutation spontanée (diode) est réalisé sous la forme d'une puce individuelle à base de matériaux semiconducteurs et les différentes puces sont ensuite montées sur un substrat (circuit imprimé ou Printed Circuit Board - PCB, cuivre à soudure directe ou Direct Bond Copper - DBC métallique, substrat métallique isolé ou Insulated Metal Substrate - IMS par exemple substrat métallique en surface d'une céramique, etc.) puis électriquement connectées pour réaliser la fonction d'onduleur de courant triphasé.

Il existe un besoin d'améliorer les onduleurs de courant triphasé et en particulier leur architecture spatiale.

Le document US 6,501,172 décrit un onduleur de tension triphasé dans lequel des commutateurs sont connectés en parallèle avec des diodes, une cellule de commutation étant constituée d'un commutateur connecté électriquement en parallèle avec une diode. Dans un ondulateur de tension, la diode d'une cellule conduit pendant que l'interrupteur (en parallèle) de la même cellule est bloqué. Pour réaliser un onduleur de tension triphasé, trois cellules sont appariées en parallèle et sont connectées avec un point commun à trois autres cellules. Ainsi, les six cellules ont un point milieu commun.

Le document US2013/0336033 décrit un composant semiconducteur intégré de puissance et son procédé de fabrication ainsi qu'un circuit convertisseur comprenant un composant semiconducteur intégré.

Le document EP 2 367 281 décrit un onduleur de courant triphasé du type auquel s'appliquent les modes de réalisation décrits. Chaque cellule de commutation comporte un commutateur commandable (un transistor) en série avec une diode. Six cellules sont connectées en série, deux par deux, entre deux bornes d'application d'une tension continue. Les points milieux des associations en série définissant les trois phases de la tension triphasée. Dans un onduleur de courant triphasé, la diode d'une cellule conduit en même temps que le commutateur avec lequel elle est en série. Les cellules sont appariées deux à deux en série et trois paires de cellules en série sont connectées en parallèle, les points milieux de chaque paire définissant une phase.

### Résumé

Un mode de réalisation pallie tout ou partie des inconvénients des onduleurs de courant triphasé.

Un mode de réalisation propose une solution permettant d'homogénéiser les contraintes de fonctionnement entre les différents interrupteurs d'un onduleur de courant triphasé.

Un mode de réalisation propose une solution particulièrement adaptée à la réalisation d'un onduleur de courant.

Ainsi, un mode de réalisation prévoit un onduleur de courant triphasé comportant deux modules de commutation triphasé, chaque module étant constitué de trois cellules de commutation identiques, comportant chacune au moins un premier interrupteur commandable électriquement en série avec au moins un deuxième interrupteur à conduction spontanée,
dans lequel les cellules d'un même module sont disposées, avec une symétrie de révolution d'ordre 3, autour d'une zone centrale conductrice d'un substrat, définissant une borne d'entrée de l'onduleur de courant triphasé à laquelle les trois cellules d'un même module sont électriquement interconnectées ; et
dans lequel les cellules du premier module et les cellules du deuxième module sont électriquement connectées deux à deux, les noeuds d'interconnexion définissant trois bornes de phase.

Selon un mode de réalisation, les interrupteurs à conduction spontanée sont montés dans la zone centrale conductrice du module correspondant avec une symétrie de révolution d'ordre 3.

Selon un mode de réalisation, la zone centrale conductrice de chaque module ne comporte aucun composant.

Selon un mode de réalisation, la zone centrale de chaque module présente également une symétrie de révolution d'ordre 3.

Selon un mode de réalisation, le ou les interrupteurs des cellules de commutation sont disposés sur des zones périphériques conductrices du substrat présentant une symétrie de révolution d'ordre 3.

Selon un mode de réalisation, la zone centrale et les zones périphériques de chaque module décrivent approximativement un Y.

Selon un mode de réalisation, la zone centrale conductrice de chaque module a une forme sensiblement hexagonale.

Selon un mode de réalisation, le ou lesdits premiers interrupteurs sont des transistors.

Selon un mode de réalisation, le ou lesdits interrupteurs à conduction spontanée sont des diodes ou des transistors MOS.

Selon un mode de réalisation, chaque interrupteur est soudé à une zone conductrice par une métallisation de face arrière d'une puce en matériaux semiconducteurs, définissant une électrode de l'interrupteur.

Selon un mode de réalisation, la zone centrale conductrice de chaque module définit une borne d'interconnexion électrique des trois cellules du module.

Selon un mode de réalisation, le substrat de chaque module est un substrat métallique isolé, de préférence sur céramique.

Un mode de réalisation prévoit un système comportant :
au moins un ensemble de panneaux photovoltaïques ; et
au moins un onduleur de courant.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique et sous forme de blocs d'un onduleur triphasé du type auquel s'appliquent les modes de réalisation décrits ;
la figure 2 représente un schéma électrique d'un onduleur de courant triphasé ;
la figure 3 est une représentation schématique d'une architecture usuelle d'un module de commutation d'un onduleur de courant triphasé ;
la figure 4 représente, de façon très schématique, un mode de réalisation d'une architecture d'un premier module d'un onduleur de courant triphasé ;
la figure 5 représente, de façon très schématique, un mode de réalisation d'une architecture d'un deuxième module d'onduleur de courant triphasé ;
la figure 6 représente le schéma électrique d'un onduleur de courant triphasé réalisé avec les modules des figures 4 et 5 ;
la figure 7 représente une variante du mode de réalisation de la figure 4 ;
la figure 8 représente une variante du mode de réalisation de la figure 5 ;
la figure 9 est une représentation très schématique et simplifiée d'une puce de circuit semiconducteur constituant un transistor de puissance vertical ;
la figure 10 est une représentation très schématique et simplifiée d'une puce de circuit semiconducteur constituant une diode verticale ;
la figure 11 représente, de façon très schématique, un autre mode de réalisation d'une architecture d'un premier module d'un onduleur de courant triphasé ;
la figure 12 représente, de façon très schématique, un autre mode de réalisation d'une architecture d'un deuxième module d'un onduleur de courant triphasé ;
la figure 13 représente le schéma électrique d'un onduleur de courant triphasé réalisé avec les modules des figures 11 et 12 ;
la figure 14 est une représentation schématique d'une variante des modes de réalisation des figures 11 et 12 ; et
la figure 15 est une représentation très schématique et partielle d'une autre variante de réalisation.

### Description détaillée

Par souci de clarté, seuls les éléments qui sont utiles à la compréhension des modes de réalisation décrits ont été représentés et seront détaillés. En particulier, la commande d'un convertisseur de puissance basé sur les onduleurs triphasés décrits n'a pas été détaillée, les modes de réalisation décrits étant compatibles avec les procédés industriels de fabrication et circuits de commande usuels. De plus, la constitution et réalisation des circuits en amont et en aval des onduleurs triphasés décrits n'ont pas non plus été détaillées, les modes de réalisation décrits étant compatibles avec les applications usuelles de tels onduleurs triphasés. Il est à noter que, sur les figures, les éléments structurels et/ou fonctionnels communs aux différents modes de réalisation peuvent présenter les mêmes références et peuvent disposer de propriétés structurelles, dimensionnelles et matérielles identiques. Sauf précision contraire, les expressions "approximativement", "sensiblement" et "de l'ordre de" signifient à 10 % près, de préférence à 5 % près, ou à 10° près, de préférence à 5° près.

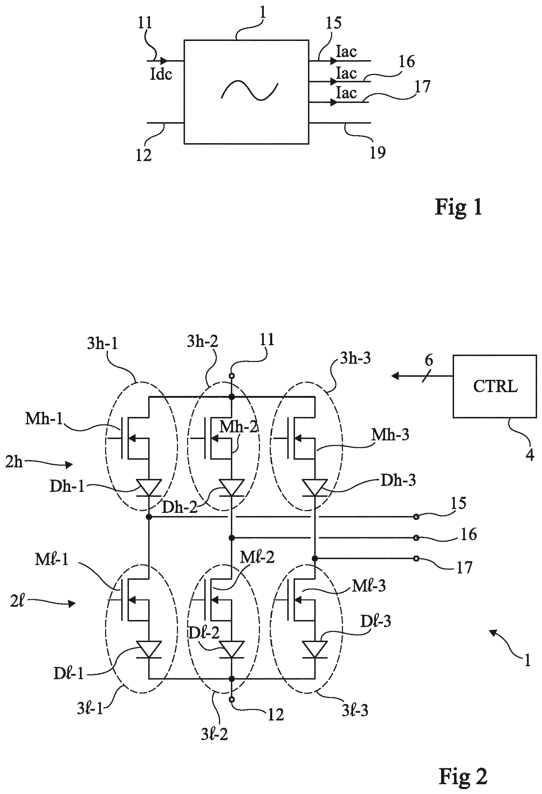

La figure 1 est une représentation schématique et sous forme de blocs d'un onduleur de courant triphasé du type auquel s'appliquent les modes de réalisation décrits.

La fonction d'un onduleur de courant triphasé 1 est de convertir un courant continu Idc circulant entre deux bornes 11 et 12 d'entrée en un courant alternatif triphasé Iac sur des bornes de sortie 15, 16, 17 et 19. Les bornes 15, 16 et 17 représentent les bornes des différentes phases et la borne 19 représente la borne de neutre optionnelle.

La figure 2 représente un schéma électrique d'un onduleur de courant triphasé.

L'onduleur 1 comporte deux modules de commutation 2h et 2l de structures internes similaires. Chaque module 2h, 2l comporte trois cellules de commutation, impliquant de manière cyclique deux des trois interrupteurs, respectivement 3h-1, 3h-2, 3h-3 et 3l-1, 3l-2, 3l-3 identiques et chacune constituée d'un transistor MOS (à canal N) respectivement Mh-1, Mh-2, Mh-3, Ml-1, Ml-2, Ml-3 en série avec une diode, respectivement Dh-1, Dh-2, Dh-3, Dl-1, Dl-2, Dl-3. Les drains des transistors Mh-1, Mh-2 et Mh-3 sont interconnectés à la borne 11 d'application d'un premier potentiel de la source de courant Idc. Les sources des transistors Mh-1, Mh-2 et Mh-3 sont respectivement connectées aux anodes des diodes Dh-1, Dh-2 et Dh-3, dont les cathodes sont connectées respectivement aux bornes 15, 16 et 17 des trois phases de tension alternative. Les drains des transistors Ml-1, Ml-2, Ml-3 sont respectivement connectés aux bornes 15, 16 et 17. Les sources des transistors Ml-1, Ml-2 et Ml-3 sont respectivement connectées aux anodes des diodes Dl-1, Dl-2 et Dl-3, dont les cathodes sont interconnectées à la borne 12 d'application d'un deuxième potentiel de la source de courant Idc.

Les grilles des transistors Mh-1, Mh-2, Mh-3, Ml-1, Ml-2, Ml-3 sont individuellement connectées à un circuit de commande 4 (CTRL) chargé d'organiser la commutation des différentes cellules pour générer un courant alternatif Iac triphasé. Dans un onduleur de courant, la circulation du courant s'effectue successivement dans chacune des cellules de commutation (par exemple 3h-1/3h-2, 3h-1/3h-3, 3h-2/3h-3) d'un premier module conjointement à chacune des cellules de commutation (par exemple 31-1/31-2, 31-1/31-3, 31-2/31-3) de l'autre module. On obtient ainsi les 9 combinaisons permettant de générer le courant alternatif triphasé avec les déphasages appropriés. La commande d'un tel onduleur de courant est usuelle.

Dans la présente description, on identifie par la lettre « h » ou « 1 » complétant une même référence numérique le module haut ou bas de l'onduleur de courant triphasé auquel appartient l'élément identifié par la référence numérique. Par ailleurs, on complète les références par «-1 », « -2 » ou « -3 » pour identifier la branche de commutation (représentant la phase de la tension alternative) à laquelle appartient l'élément identifié par la référence numérique. Ces compléments de référence pourront être omis lorsqu'une distinction n'a pas besoin d'être faite pour les besoins de l'exposé.

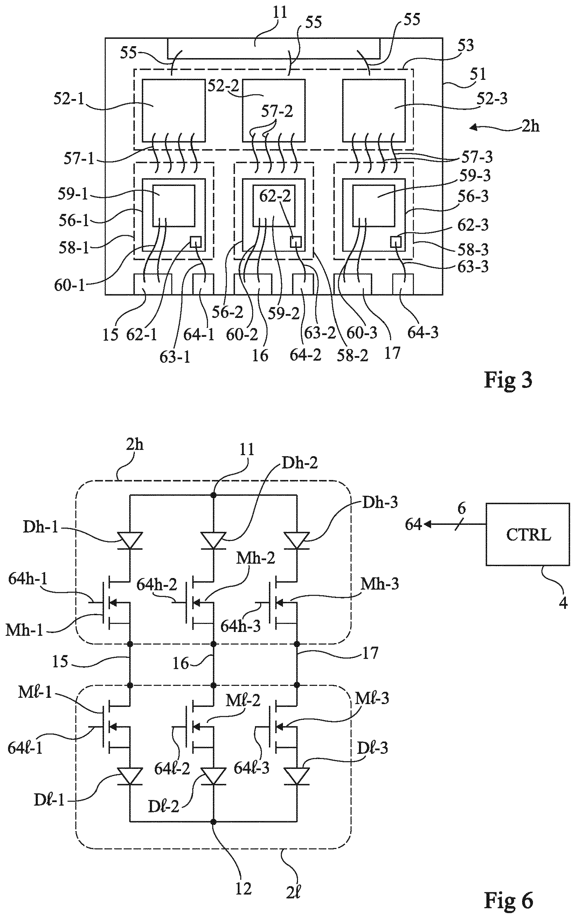

La figure 3 est une représentation schématique d'une architecture usuelle d'un module de commutation d'un onduleur de courant triphasé.

Dans les applications de puissance visées par la présente description, les transistors et diodes sont réalisés sous la forme de composants verticaux en matériaux semiconducteurs montés en surface d'un substrat métallique isolé 51.

Dans l'exemple de la figure 3, on considère un module haut 2h, dont les diodes et transistors sont inversés par rapport à la figure 2. Ce sont donc les anodes des diodes Dh-1, Dh-2, Dh-3 qui sont interconnectées à la borne 11. Les trois diodes Dh-1, Dh-2 et Dh-3 sont réalisées individuellement sur des substrats de type P et les cathodes sont réalisées par des régions de type N dans ces substrats. Les électrodes d'anode, généralement réalisées sous la forme d'une métallisation de face arrière des puces formant les diodes Dh-1, Dh-2, Dh-3, et sont rapportées sur une zone conductrice 53 (typiquement un plan conducteur métallique) du substrat métallique isolé 51. Une zone électriquement conductrice du substrat métallique isolé définissant la borne 11 est raccordée au plan 53 par un ou plusieurs fils 55. Les transistors Mh-1, Mh-2 et Mh-3 sont également réalisés individuellement sous forme de puces 56-1, 56-2 et 56-3. L'électrode de drain de chaque transistor, généralement réalisée sous la forme d'une métallisation en face arrière de la puce, est rapportée sur une zone conductrice 58-1, 58-2 et 58-3 respectivement du substrat métallique isolé 51. Les électrodes de cathode correspondant à des métallisations de face avant 52-1, 52-2 et 52-3 des puces formant les diodes Dh-1, Dh-2 et Dh-3 sont respectivement électriquement connectées aux zones 58-1, 58-2 et 58-3 par un ou plusieurs fils 57-1, 57-2, 57-3. L'électrode de source de chaque transistor Mh-1, Mh-2, Mh-3 correspond à un contact métallique de face avant, respectivement 59-1, 59-2, 59-3, connecté par un ou plusieurs fils 60-1, 60-2, 60-3 à un contact du substrat métallique isolé, définissant une borne, respectivement 15, 16, 17. Les grilles des transistors Mh-1, Mh-2 et Mh-3 sont reprises en face avant des puces par des contacts 62-1, 62-2 et 62-3, connectés individuellement par un ou plusieurs fils 63-1, 63-2, 63-3, à des contacts respectifs du substrat métallique isolé 51, définissant des bornes 64-1, 64-2, 64-3 destinées à être raccordées au circuit de commande 4 (figure 2).

Une architecture telle qu'illustrée en figure 3 dans laquelle les puces sont juxtaposées engendre des contraintes de fonctionnement, thermiques et électriques, différentes selon les phases de fonctionnement, ce qui nuit à sa fiabilité.

Par ailleurs, on assiste à un déséquilibre entre les différentes mailles de conduction, ce qui nuit également au fonctionnement.

Les modes de réalisation qui vont être décrits partent d'une nouvelle analyse basée sur l'architecture ou la disposition des différentes cellules de commutation sur un substrat métallique isolé. Cette analyse prend en compte la particularité d'un onduleur de courant qui est que deux des trois interrupteurs sont impliqués de manière cyclique lors des commutations.

On prévoit notamment de rendre les contraintes électriques et thermiques subies par les différentes puces du commutateur identiques quelle que soit la phase. Ainsi, on homogénéise le vieillissement, ce qui accroit la fiabilité des commutateurs.

Plus particulièrement, on prévoit de disposer au moins les interrupteurs des cellules de commutation autour (en périphérie) d'une zone centrale avec, dans le plan, une symétrie de révolution d'ordre 3 par rapport au centre de la structure. En d'autres termes, la structure présente sensiblement une symétrie de révolution de 120°.

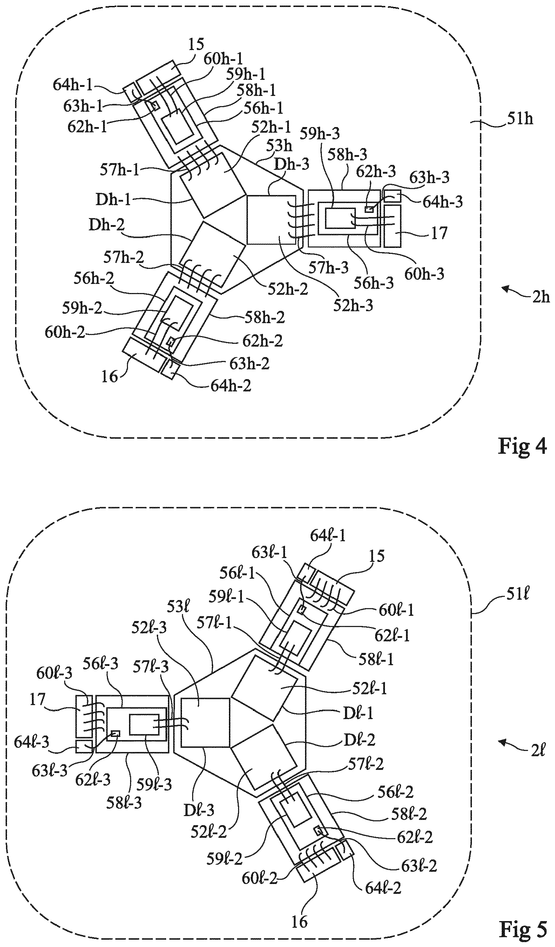

La figure 4 représente, de façon très schématique, un mode de réalisation d'une architecture d'un premier module 2h d'un onduleur de courant triphasé.

La figure 5 représente, de façon très schématique, un mode de réalisation d'une architecture d'un deuxième module 21 d'un onduleur de courant triphasé.

Dans l'exemple des figures 4 et 5, on considère une structure en étoile ou en Y dans laquelle, pour chaque module 2h, 21, les trois diodes des cellules sont disposées au centre de la structure et les transistors sont disposés dans les branches du Y.

Comme précédemment, les diodes et transistors sont réalisés individuellement sous forme de puces discrètes de composants verticaux en matériaux semiconducteurs, et sont montés sur un substrat métallique isolé 51, désigné 51h en figure 4 pour le premier module 2h et 511 en figure 5 pour le deuxième module 21. Une zone métallisée centrale 53h (figure 4), 531 (figure 5), a une forme symétrique de révolution d'ordre 3 dans le plan par rapport à son centre, par exemple une forme hexagonale. Trois zones métallisées périphériques 58h-1, 58h-2, 58h-3 (figure 4), respectivement 581-1, 581-2, 581-3 (figure 5) sont réalisées dans chaque portion 51h, 511 du substrat métallique isolé. Par exemple, chaque zone 58 est rectangulaire et a un bord parallèle à un côté de l'hexagone 53 autour duquel elle est prévue, un côté libre de la zone hexagonale 53 séparant deux côtés ayant chacun une zone 58 en regard.

Dans le mode de réalisation des figures 4 et 5, on prévoit de placer les diodes aux centres des structures. Par conséquent, pour le module 2h (figure 4), les électrodes d'anode des diodes Dh-1, Dh-2, Dh-3 sont montées (soudées) sur la zone 53h, tandis que pour le module 21, les électrodes de cathode des diodes Dl-1, Dl-2, Dl-3 (figure 5) sont montées (soudées) sur la zone 531. Le schéma électrique qui sera exposé par la suite en relation avec la figure 6 est donc différent de celui de la figure 2.

Le contact de drain en face arrière de chaque puce 56h-1, 56h-2, 56h-3 (figure 4), 56l-1, 56l-2 et 56l-3 (figure 5), formant un transistor Ml-1, Ml-2, Ml-3 (figure 4), Mh-1, Mh-2, Mh-3 (figure 5), est monté (soudé) sur une zone 58, respectivement 58h-1, 58h-2, 58h-3 (figure 4) ou 58l-1, 58l-2, 58l-3 (figure 5) du module concerné.

Pour le module 2h (figure 4), les électrodes de cathode correspondant à des métallisations de face avant 52h-1, 52h-2 et 52h-3 des puces formant les diodes Dh-1, Dh-2 et Dh-3 sont respectivement électriquement connectées aux zones 58h-1, 58h-2 et 58h-3 par un ou plusieurs fils 57h-1, 57h-2, 57h-3. L'électrode de source de chaque transistor Mh-1, Mh-2, Mh-3 correspond à un contact métallique de face avant, respectivement 59h-1, 59h-2, 59h-3 connecté par un ou plusieurs fils 60h-1, 60h-2, 60h-3, à un contact du circuit imprimé, définissant une borne, respectivement 15, 16, 17. Les grilles des transistors Mh-1, Mh-2 et Mh-3, sont reprises en face avant des puces 56 par des contacts 62h-1, 62h-2, 62h-3. Ces contacts sont connectés individuellement par un ou plusieurs fils 63h-1, 63h-2, 63h-3, à des contacts respectifs du circuit imprimé, définissant des bornes 64h-1, 64h-2, 64h-3, destinées à être raccordées au circuit de commande 4 (figure 2).

Pour le module 21 (figure 5), les électrodes d'anode correspondant à des métallisations de face avant 541-1, 541-2 et 541-3 des puces formant les diodes Dl-1, Dl-2 et Dl-3 sont respectivement électriquement connectées, par un ou plusieurs fils 57l-1, 57l-2, 57l-3, aux électrodes de source respectives des transistors Ml-1, Ml-2 et Ml-3 correspondant à un contact métallique de face avant, respectivement 59l-1, 59l-2, 59l-3 des puces formant les transistors. Les zones 58l-1, 58l-2 et 58l-3 sont respectivement connectées, par un ou plusieurs fils 601-1, 60l-2, 60l-3, à un contact du substrat métallique isolé, définissant une borne, respectivement 15, 16, 17. Les grilles des transistors Ml-1, Ml-2 et Ml-3, sont reprises en face avant des puces 56 par des contacts 62l-1, 62l-2, 62l-3. Ces contacts sont connectés individuellement par un ou plusieurs fils 63l-1, 63l-2, 63l-3, à des contacts respectifs du substrat métallique isolé, définissant des bornes 64l-1, 64l-2, 64l-3, destinées à être raccordées au circuit de commande 4 (figure 2).

La figure 6 représente le schéma électrique d'un onduleur de courant réalisé avec les modules des figures 4 et 5.

Par rapport au schéma de la figure 2, les positions respectives des diodes et transistors du module haut 2h sont inversées, c'est-à-dire que les diodes Dh ont leurs anodes interconnectées à la borne 11 tandis que les transistors Mh-1, Mh-2 et Mh-3 ont leurs sources respectives connectées aux bornes 15, 16 et 17. Le module bas 21 est, du point de vue raccordement électrique, similaire à celui de la figure 2.

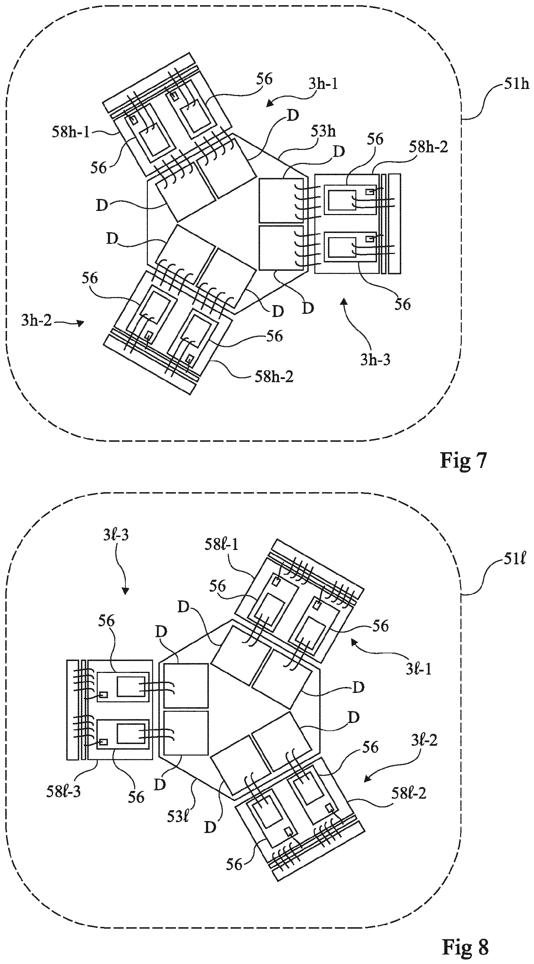

La figure 7 représente une variante du mode de réalisation de la figure 4.

La figure 8 représente une variante du mode de réalisation de la figure 5.

Ces figures 7 et 8 illustrent la possibilité de prévoir, au niveau de chaque cellule 3 de commutation, plusieurs diodes et transistors en parallèle. Ainsi, aux figures 7 et 8, les zones métalliques 58h-1, 58h-2, 58h-3, 58l-1, 58l-2, 58l-3 des substrats métalliques isolés 51h et 51l reçoivent chacune par exemple deux puces 56 de transistors et les zones centrales 53h et 53l reçoivent chacune trois paires de diodes D. Les connexions sont similaires à celles exposées en relation avec les figures 4 et 5.

Un agencement des puces tel qu'illustré aux figures 4 et 5, ou 7 et 8, présente l'avantage d'homogénéiser le comportement électrique et thermique des différentes mailles de circulation de courant. En effet, la symétrie géométrique entre les différentes cellules de commutation entraîne que les trois mailles de commutation possibles 3h-1/3h-2, 3h-2/3h-3 et 3h-1/3h-3 pour le module haut 2h et les trois mailles de commutation possibles 3l-1/3l-2, 3l-2/3l-3 et 3l-1/3l-3 pour le module bas 2l présentent un même comportement électrique. En particulier, les impédances des différentes mailles de commutation utilisées sont identiques et les niveaux de surtension vus par les différents interrupteurs sont identiques. De plus, leur comportement thermique est également homogénéisé grâce à cette symétrie géométrique.

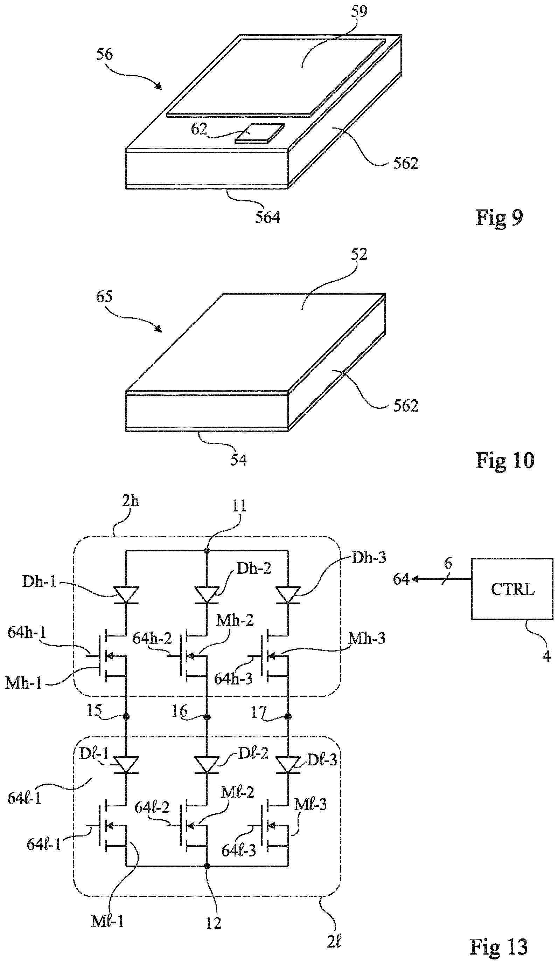

La figure 9 est une représentation très schématique et simplifiée d'une puce 56 de circuit semiconducteur constituant un transistor de puissance M vertical.

Selon cet exemple, le transistor M est réalisé dans un substrat 562 dans lequel les régions de source et de drain sont formées. Une métallisation face arrière 564 (généralement pleine plaque) définit le contact de drain D. En face avant des zones 59 et 62 de métallisation définissent les contacts de source S et de grille G. Le cas échéant, plusieurs zones parallèles 59 sont présentes. La puce 56 est, de préférence, destinée à être montée par sa face arrière sur un substrat métallique isolé.

La figure 10 est une représentation très schématique et simplifiée d'une puce 65 de circuit semiconducteur constituant une diode D verticale.

Selon cet exemple, la diode D est réalisée dans un substrat 652 dont la face avant est dopée P. Une métallisation face arrière 54 (par exemple pleine plaque) définit l'électrode de cathode tandis qu'une métallisation de face avant 52 (par exemple pleine plaque) définit l'électrode d'anode.

Dans les modes de réalisation des figures 4, 5, 7 et 8, les diodes Dh-1, Dh-2 et Dh-3 sont montées sur le substrat métallique isolé par leur métallisation d'anode, c'est-à-dire par l'électrode de type P. Il peut être souhaitable de pouvoir monter toutes les diodes de l'onduleur de courant en rapportant leurs électrodes de cathode sur le substrat métallique isolé.

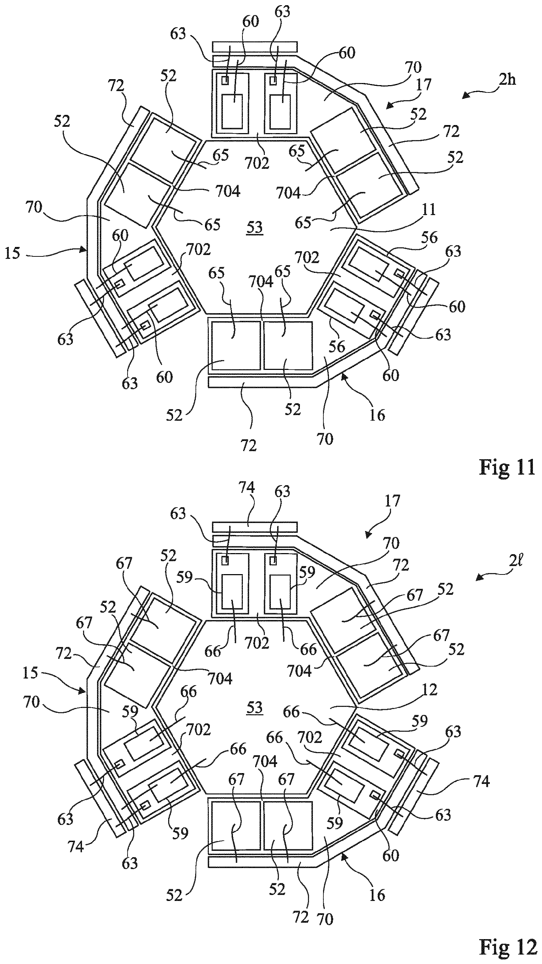

La figure 11 représente, de façon très schématique, un autre mode de réalisation d'une architecture d'un premier module 2h d'un onduleur de courant triphasé.

La figure 12 représente, de façon très schématique, un autre mode de réalisation d'une architecture d'un deuxième module 21 d'un onduleur de courant triphasé.

Les modes de réalisation des figures 11 et 12 répondent à l'objectif de monter toutes les diodes en rapportant leurs électrodes de cathode sur le substrat métallique isolé.

Pour cela, on prévoit de modifier le montage électrique, c'est-à-dire le schéma électrique de l'onduleur de courant triphasé.

La figure 13 représente, de façon très schématique, le schéma électrique d'un onduleur de courant triphasé selon le mode de réalisation des figures 11 et 12.

D'un point de vue schéma électrique, le module haut 2h est identique à celui du mode de réalisation de la figure 6, c'est-à-dire que les diodes Dh ont toutes leurs anodes connectées à la borne 11 et que les sources des transistors Mh-1, Mh-2 et Mh-3 sont respectivement connectées aux bornes 15, 16, et 17. Les cellules du module bas 21 ont cependant les positions des diodes et transistors inversées par rapport au mode de réalisation de la figure 6. En d'autres termes, les anodes respectives des diodes Dl-1, Dl-2 et Dl-3 sont respectivement connectées aux bornes 15, 16 et 17, et les sources des transistors Ml-1, Ml-2 et Ml-3 sont toutes connectées à la borne 12. Comme dans les modes de réalisation précédents, les grilles 64 des transistors sont connectées à un circuit de commande 4.

L'architecture décrite en relation avec les figures 11 et 12 est basée sur des zones métallisées centrales 53 de forme hexagonale sur lesquelles n'est rapporté aucun composant. Ces zones définissent respectivement les bornes 11 et 12 de l'onduleur de courant triphasé. Par ailleurs, toutes les cellules de commutation sont structurellement identiques et ne diffèrent que par les raccordements par fil(s) réalisés une fois les composants montés sur le substrat métallique isolé. Ainsi, pour toutes les cellules de commutation, on prévoit des premières portions métallisées 70 identiques, ayant chacune la forme d'une portion d'une bande annulaire hexagonale décrivant deux côtés de l'hexagone. Chaque extrémité d'une portion 70 est, par exemple, orthogonale au tronçon d'hexagone qu'elle termine. Par ailleurs, chaque portion 70 reçoit des diodes et transistors identiques et montés de la même manière, c'est-à-dire par leurs faces arrières respectives.

Dans l'exemple des figures 11 et 12, on prévoit deux transistors M et deux diodes D par cellule de commutation mais on pourrait ne prévoir qu'un transistor et une diode ou plus de deux de chaque. De préférence, afin de respecter la symétrie, les transistors M sont tous montés sur des premiers tronçons 702 des portions 70 respectives et les diodes sont toutes pontées sur des deuxièmes tronçons 704 de ces portions 70.

Chaque portion 70 est associée à une autre portion conductrice 72 d'hexagone annulaire entourant le premier (celui dans lequel sont formées les portions 70). Bien entendu, comme pour entre la zone 53 et les portions 70, les portions 70 et les portions 72 sont espacées les unes des autres afin d'être isolées électriquement. Enfin, au droit des tronçons 702 portant les transistors M, une bande conductrice 74 définissant la borne de grille du ou des transistors de chaque cellule est prévue à l'extérieur de la portion 72 correspondante.

Toutes les diodes et tous les transistors M sont montés sur les portions conductrices 70 par leurs faces arrières respectives. Par conséquent, pour les transistors, les contacts apparents (supérieurs) sont les contacts 59 de source et les contacts 62 de grille. Pour les diodes D, la métallisation apparente 52 correspond à l'électrode d'anode.

Quel que soit le module, les contacts de grille 62 sont connectés par des fils 63 aux bandes conductrices respectives des cellules.

Pour le module haut 2h (figure 11), les contacts d'anode 52 de toutes les diodes D sont connectés par des fils 65 à la portion centrale 53, tandis que les contacts de source 59 des différents transistors M sont connectés à la portion 72 de la cellule correspondante par des fils 60.

Pour le module bas 21 (figure 12), tous les contacts de source 59 des transistors M sont connectés à la portion centrale 53 (borne 12) par des fils 66, tandis que les contacts d'anode 52 des différentes diodes D sont connectés à la portion 72 de la cellule correspondante par des fils 67.

On voit donc que les deux seules différences entre les modules haut et les modules bas sont les connexions par fils 60 ou 66 des sources des transistors et par fils 65 ou 67 des anodes des diodes.

Une telle réalisation facilite la fabrication en autorisant des structures communes pour les modules haut et bas le plus longtemps possible dans le processus industriel.

En variante, les fils de raccordement prévus aux figures 11 et 12 sont remplacés par des éléments rigides de connexion plans (connexion planar).

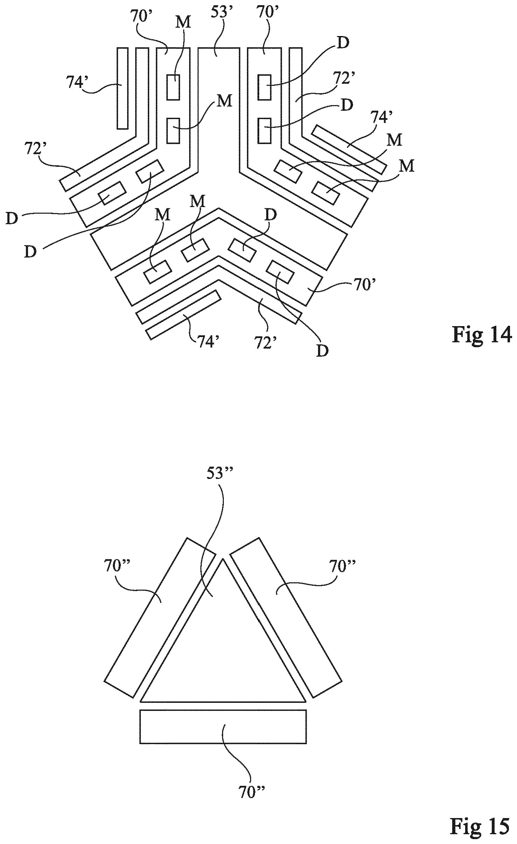

La figure 14 est une représentation schématique d'une variante de réalisation d'un module des figures 11 et 12 dans laquelle la zone centrale 53' a la forme d'un Y.

Des portions 70', similaires aux portions 70 décrites en relation avec les figures 11 et 12, portent les diodes D et les transistors M mais leur disposition est inversée afin d'épouser, à forme complémentaire, la forme en Y de la zone centrale 53'. De même, des portions 72' et 74', similaires aux portions 72 et 74 des figures 11 et 12 sont prévues pour définir les bornes 15, 16 et 17 ainsi que les bornes de commande des transistors. Pour simplifier la représentation de la figure 14, les connexions filaires n'ont pas été représentées.

La figure 15 est une représentation schématique d'une autre variante de réalisation d'un module dans laquelle la zone centrale 53" est triangulaire et les zones 72" sont rectilignes et parallèles aux côtés du triangle de la zone 53". Pour simplifier, le reste du module n'a pas été représenté en figure 15.

D'autres formes peuvent être prévues pour les zones métalliques du circuit imprimé de réception des cellules de commutation, pourvu de respecter une zone centrale et des zones périphériques présentant une symétrie de révolution d'ordre 3, c'est-à-dire un décalage d'environ 120 degrés, de préférence d'exactement 120 degrés, d'une cellule à l'autre autour du centre du plan dans lequel s'inscrit le module.

Un avantage des modes de réalisation qui ont été décrits est qu'il est désormais possible de réaliser un onduleur de courant triphasé dans lequel les comportements électrique et thermique des différentes mailles de commutation sont identiques.

Les modes de réalisation décrits s'appliquent tout particulièrement à des applications de conversion d'énergie fournie par des panneaux photovoltaïques.

Divers modes de réalisation et variantes ont été décrits. Certains modes de réalisation et variantes pourront être combinés et d'autres variantes et modifications apparaîtront à l'homme de l'art. En particulier, les zones électriquement conductrices du substrat sont bien entendu séparées les unes des autres de façon à être isolées électriquement. De plus, ces zones peuvent être reliées par des pistes conductrices ou fils à d'autres régions métalliques du substrat, en particulier pour raccorder l'onduleur à des circuits amont et aval. Par ailleurs, bien que l'on ait fait plus particulièrement référence à l'utilisation d'un substrat métallique isolé, de préférence un substrat métallique sur céramique, le substrat sur lequel sont montés les composants peut être tout autre substrat adapté, par exemple un circuit imprimé, un substrat à cuivre à soudure directe, etc. De plus, chaque interrupteur peut en fait être formé de plusieurs interrupteurs en parallèle. Le choix des dimensions et du nombre de puces à assembler en parallèle pour réaliser chaque interrupteur d'un onduleur dépend de l'application et, entre autres, de la puissance de fonctionnement souhaitée.

En outre, bien que les modes de réalisation aient été décrits en relation avec un exemple appliqué à des cellules de commutation constituées d'un transistor MOS en série avec une diode, ils se transposent à d'autres structures de cellules de commutation triphasées réalisant ou non un interrupteur bidirectionnel en tension et unidirectionnel en courant, dans lesquelles des problèmes similaires se posent. Par exemple, la fonction diode peut être réalisée par un transistor MOS. Dans ce cas, toutes les cellules sont identiques et les modules haut et bas peuvent également être de structure identique et comporter des connexions filaires identiques.

On notera que les deux modules d'un même onduleur de courant triphasé ne sont pas nécessairement appariés sur un même circuit intégré (dans un même plan) mais peuvent être superposés avec interposition d'un isolant (par exemple face arrière contre face arrière des circuits imprimés portant les modules), en raccordant les bornes 15, 16 et 17 par des vias.

Enfin, la mise en oeuvre pratique des modes de réalisation et variantes qui ont été décrits est à la portée de l'homme de métier à partir des indications fonctionnelles données ci-dessus.

## Revendications

1. Onduleur de courant triphasé comportant deux modules de commutation triphasé, chaque module étant constitué de trois cellules de commutation (3h-1, 3h-2, 3h-3 ; 3l-1, 3l-2, 3l-3) identiques, comportant chacune au moins un premier interrupteur commandable (M) électriquement en série avec au moins un deuxième interrupteur à conduction spontanée (D),
dans lequel les cellules d'un même module sont disposées, avec une symétrie de révolution d'ordre 3, autour d'une zone centrale conductrice (53h ; 53l ; 53 ; 53' ; 53") d'un substrat (51l, 51h), définissant une borne d'entrée (11, 12) de l'onduleur de courant triphasé à laquelle les trois cellules d'un même module sont électriquement interconnectées ; et
dans lequel les cellules (3h-1, 3h-2, 3h-3) du premier module et (2h) et les cellules (3l-1, 3l-2, 3l-3) du deuxième modules (2l) sont électriquement connectées deux à deux, les noeuds d'interconnexion définissant trois bornes de phase (15, 16, 17).

2. Onduleur selon la revendication 1, dans lequel les interrupteurs à conduction spontanée (D) sont montés dans la zone centrale conductrice (53h, 531) du module correspondant avec une symétrie de révolution d'ordre 3.

3. Onduleur selon la revendication 1, dans lequel la zone centrale conductrice (53 ; 53' ; 53") de chaque module ne porte aucun composant.

4. Onduleur selon l'une quelconque des revendications 1 à 3, dans lequel la zone centrale (53h ; 53l ; 53 ; 53' ; 53") de chaque module présente également une symétrie de révolution d'ordre 3.

5. Onduleur selon l'une quelconque des revendications 1 à 4, dans lequel le ou les interrupteurs des cellules de commutation (3h-1, 3h-2, 3h-3 ; 3l-1, 3l-2, 3l-3) sont disposés sur des zones périphériques conductrices (58h-1, 58h-2, 58h-3 ; 58l-1, 58l-2, 58l-3 ; 70 ; 70' ; 70") du substrat (51, 51h) présentant une symétrie de révolution d'ordre 3.

6. Onduleur selon la revendication 5, dans lequel la zone centrale (53h ; 53l) et les zones périphériques (58h-1, 58h-2, 58h-3 ; 58l-1, 58l-2, 58l-3) de chaque module décrivent approximativement un Y.

7. Onduleur selon l'une quelconque des revendications 1 à 6, dans lequel la zone centrale conductrice (53 ; 53h, 53l ; 53') de chaque module a une forme sensiblement hexagonale.

8. Onduleur selon l'une quelconque des revendications 1 à 7, dans lequel le ou lesdits premiers interrupteurs sont des transistors.

9. Onduleur selon l'une quelconque des revendications 1 à 8, dans lequel le ou lesdits interrupteurs à conduction spontanée sont des diodes (D) ou des transistors MOS.

10. Onduleur selon l'une quelconque des revendications 1 à 9, dans lequel chaque interrupteur (M ; D) est soudé à une zone conductrice (53h ; 531 ; 53 ; 53' ; 53" ; 58h-1, 58h-2, 58h-3 ; 58l-1, 58l-2, 58l-3 ; 70 ; 70' ; 70") par une métallisation de face arrière (564 ; 54) d'une puce en matériaux semiconducteurs, définissant une électrode de l'interrupteur.

11. Onduleur selon l'une quelconque des revendications 1 à 10, dans lequel la zone centrale conductrice (53h ; 53l ; 53 ; 53' ; 53") de chaque module définit une borne (11 ; 12) d'interconnexion électrique des trois cellules du module.

12. Onduleur selon l'une quelconque des revendications 1 à 11, dans lequel le substrat de chaque module est un substrat métallique isolé, de préférence sur céramique.

13. Système comportant :
un ensemble de panneaux photovoltaïques ; et
un onduleur selon l'une quelconque des revendications 1 à 12.

## Patentansprüche

1. Dreiphasenwechselrichter mit zwei dreiphasigen Schalteinheiten, wobei jede Einheit aus drei identischen Schaltzellen (3h-1, 3h-2, 3h-3; 3l-1, 3l-2, 3l-3) gebildet ist, die jeweils wenigstens einen ersten elektrisch gesteuerten Schalter (M) in Reihe mit mindestens einem zweiten spontan leitenden Schalter (D) aufweisen,
wobei die Zellen einer gleichen Einheit mit einer Rotationssymmetrie der Ordnung 3 um einen leitenden zentralen Bereich (53h; 53l; 53; 53'; 53") eines Substrats (51l, 51h) angeordnet sind, der einen Eingangsanschluss (11, 12) des Dreiphasenwechselrichter definiert, mit dem die drei Zellen einer gleichen Einheit verbunden sind; und
wobei die Zellen (3h-1, 3h-2, 3h-3l-3) der ersten Einheit (2h) und die Zellen (3l-2, 3l-3) der zweiten Einheit (2l) paarweise elektrisch miteinander verbunden sind, wobei die Verbindungsknoten einen Dreiphasenanschluss (15, 16, 17) definieren.

2. Wechselrichter nach Anspruch 1, wobei die spontan leitenden Schalter (D) im leitenden Zentralbereich (53h, 53l) der entsprechenden Einheit mit einer Rotationssymmetrie der Ordnung 3 angeordnet sind.

3. Wechselrichter nach Anspruch 1, wobei der leitende Zentralbereich (53; 53'; 53") jeder Einheit kein Bauteil trägt.

4. Wechselrichter nach einem der Ansprüche 1 bis 3, wobei der zentrale Bereich (53h; 53l; 53; 53'; 53") jeder Einheit ebenfalls eine Rotationssymmetrie der Ordnung 3 aufweist.

5. Wechselrichter nach einem der Ansprüche 1 bis 4, wobei der/die Schalter der Schaltzellen (3h-1, 3h-2, 3h-3; 3l-1, 3l-2, 3l-3) an leitfähigen Randbereichen (58h-1, 58h-2, 58h-3; 58l-1, 58l-2, 58l-3; 70; 70'; 70") des Substrats (51, 51h) mit einer Rotationssymmetrie der Ordnung 3 angeordnet sind.

6. Wechselrichter nach Anspruch 5, wobei der zentrale Bereich (53h; 53l) und die Randbereiche (58h-1, 58h-2, 58h-3; 58l-1, 58l-2, 58l-3) jeder Einheit ungefähr ein Y bilden.

7. Wechselrichter nach einem der Ansprüche 1 bis 6, wobei der leitende zentrale Bereich (53; 53h, 53l; 53') jeder Einheit eine im Wesentlichen hexagonale Form aufweist.

8. Wechselrichter nach einem der Ansprüche 1 bis 7, wobei der (die) erste(n) Schalter Transistoren sind.

9. Wechselrichter nach einem der Ansprüche 1 bis 8, wobei der (die) spontan leitende(n) Schalter Dioden (D) oder MOS-Transistoren sind.

10. Wechselrichter nach einem der Ansprüche 1 bis 9, wobei jeder Schalter (M; D) an einen leitenden Bereich (53h; 53l; 53; 53'; 53"; 58h-1, 58h-2, 58h-3; 58l-1, 58l-2, 58l-3; 70; 70'; 70") geschweißt ist mittel einer Rückseitenmetallisierung (564; 54) eines Chips aus Halbleitermaterialien, die eine Elektrode des Schalters definiert.

11. Wechselrichter nach einem der Ansprüche 1 bis 10, wobei der leitende zentrale Bereich (53h; 53l; 53; 53'; 53") jeder Einheit einen Anschluss (11; 12) der elektrischen Verbindung der drei Zellen der Einheit definiert.

12. Wechselrichter nach einem der Ansprüche 1 bis 11, wobei das Substrat jeder Einheit ein isoliertes Metallsubstrat, vorzugsweise auf Keramik, ist.

13. Ein System, das Folgendes aufweist:
eine Anordnung von Photovoltaik-Paneelen; und
den Wechselrichter nach einem der Ansprüche 1 bis 12.

## Claims

1. A three-phase current inverter comprising two three-phase switching units, each unit being formed of three identical switching cells (3h-1, 3h-2, 3h-3; 3l-1, 3l-2, 3l-3), each comprising at least one first electrically-controlled switch (M) in series with at least one second spontaneous conduction switch (D),
wherein the cells of a same unit are arranged, with a symmetry of revolution of order 3, around a conductive central area (53h; 53l; 53; 53'; 53") of a substrate (51l, 51h), defining an input terminal (11, 12) of the three-phase current inverter to which are interconnected the three cells of a same unit; and
wherein the cells (3h-1, 3h-2, 3h-3l-3) of the first unit (2h) and the cells (3l-2, 3l-3) of the second unit (2l) are electrically connected two by two, the interconnecting nodes defining three phase terminal (15, 16, 17).

2. The inverter of claim 1, wherein the spontaneous conduction switches (D) are assembled in the conductive central area (53h, 53l) of the corresponding unit with a symmetry of revolution of order 3.

3. The inverter of claim 1, wherein the conductive central area (53; 53'; 53") of each unit supports no component.

4. The inverter of any of claims 1 to 3, wherein the central area (53h; 531; 53; 53'; 53") of each unit also has a symmetry of revolution of order 3.

5. The inverter of any of claims 1 to 4, wherein the switch(es) of the switching cells (3h-1, 3h-2, 3h-3; 3l-1, 3l-2, 31-3) are arranged on conductive peripheral areas (58h-1, 58h-2, 58h-3; 58l-1, 58l-2, 58l-3; 70; 70'; 70") of the substrate (51, 51h) having a symmetry of revolution of order 3.

6. The inverter of claim 5, wherein the central area (53h; 53l) and the peripheral areas (58h-1, 58h-2, 58h-3; 58l-1, 58l-2, 58l-3) of each unit approximately form a Y.

7. The inverter of any of claims 1 to 6, wherein the conductive central area (53; 53h, 53l; 53') of each unit has a substantially hexagonal shape.

8. The inverter of any of claims 1 to 7, wherein said first switch(es) are transistors.

9. The inverter of any of claims 1 to 8, wherein said spontaneous conduction switch(es) are diodes (D) or MOS transistors.

10. The inverter of any of claims 1 to 9, wherein each switch (M; D) is welded to a conductive area (53h; 53l; 53; 53'; 53"; 58h-1, 58h-2, 58h-3; 58l-1, 58l-2, 58l-3; 70; 70'; 70") by a back-side metallization (564; 54) of a chip made of semiconductor materials, defining an electrode of the switch.

11. The inverter of any of claims 1 to 10, wherein the conductive central area (53h; 53l; 53; 53'; 53") of each unit defines a terminal (11; 12) of electric interconnection of the three cells of the unit.

12. The inverter of any of claims 1 to 11, wherein the substrate of each unit is an insulated metal substrate, preferably on ceramic.

13. A system comprising:
an assembly of photovoltaic panels; and
the inverter of any one of claims 1 to 12.
